# EUROPEAN PATENT APPLICATION

(11) **EP 4 462 473 A1**
(43) Date of publication of application: **13.11.2024**
(21) Application number: 24174723.7
(22) Date of filing: 08.05.2024
(51) Int. Cl.: H01L 21/768, H01L 21/8234, H01L 21/8238, H01L 23/48, H01L 23/528, H01L 23/535, H01L 27/118, H01L 29/06, H01L 29/423, H01L 29/66, H01L 29/775, H01L 29/786

(54) **SEMICONDUCTOR DEVICES**

(30) Priority: 08.05.2023 KR 20230059108
(71) Applicant: Samsung Electronics Co., Ltd., Suwon-si, Gyeonggi-do 16677 (KR)
(72) Inventor: KIM, Heesub, 16677 Suwon-si (KR); JO, Gunho, 16677 Suwon-si (KR); KIM, Bomi, 16677 Suwon-si (KR); CHO, Eunho, 16677 Suwon-si (KR)
(74) Representative: Marks & Clerk LLP

(57) **Abstract**

A semiconductor device (100) includes a substrate (101) having active regions (105) extending in a first direction (x), a device isolation layer (110) in the substrate (101) between the active regions (105) and exposing upper surfaces of the active regions (105), gate structures (160) on the active regions, intersecting the active regions and extending in a second direction (y), source/drain regions (150) adjacent to the gate structure (160) and on the active region (105), contact plugs (170) on the source/drain region (150), the contact plugs extending into respective recesses in the source/drain regions and electrically connected to the source/drain regions (150), a first power structure (VS1) between adjacent source/drain region (150) in the second direction (y) and electrically connected to at least one of the contact plugs (170), and a second power structure (VS2) penetrating the substrate (101) and on a lower end of the first power structure (VS1), and a lateral dielectric layer (155) on surfaces of the source/drain regions (105) and extending along an upper surface of the device isolation layer (110) and on a first portion of a side surface of the first power structure (VS1). The first power structure (VS1) has a first width (W1) at an upper thereof and a second width (W2) at the lower end thereof, the second width being equal to or greater than the first width.

## Description

### FIELD

The present inventive concept relates to semiconductor devices.

### BACKGROUND

As demand for high performance, high speed, and/or multifunctionality of semiconductor devices increase, the degree of integration of semiconductor devices is increasing. According to the trend for high integration of semiconductor devices, semiconductor devices having a Back Side Power Delivery Network (BSPDN) structure in which power rails are disposed on the rear surface of a wafer are being developed. In addition, to address limitations of operating characteristics due to size reductions of planar metal oxide semiconductor field effect transistors (FETs), efforts are being made to develop semiconductor devices such as fin field effect transistors (FinFETs) having a 3D structured channel.

### SUMMARY

An aspect of the present inventive concept is to provide a semiconductor device having improved electrical characteristics and facilitated processing.
According to example embodiments, a semiconductor device includes a substrate having active regions extending in a first direction, a device isolation layer in the substrate between the active regions and exposing upper surfaces of the active regions, gate structures on the active regions, intersecting the active regions and extending in a second direction, source/drain regions adjacent to the gate structures and on the active regions, contact plugs on the source/drain regions and extending into respective recesses in the source/drain regions and electrically connected to the source/drain regions, a first power structure between adjacent source/drain regions of the source/drain regions in the second direction and electrically connected to at least one of the contact plugs, a second power structure on a lower end of the first power structure and penetrating the substrate, and a lateral dielectric layer on surfaces of the source/drain regions and extending along an upper surface of the device isolation layer and on a first portion of a side surface of the first power structure. The first power structure has a first width at an upper end thereof and a second width at the lower end thereof, the second width being equal to or greater than the first width.

According to example embodiments, a semiconductor device includes a substrate having an active region extending in a first direction, a gate structure on the active region, intersecting the active region and extending in a second direction, a source/drain region adjacent to the gate structure and on the active region, a contact plug on the source/drain region and electrically connected to the source/drain regions, a first power structure on one side of the source/drain region in the second direction and electrically connected to the contact plug, and a second power structure penetrating the substrate and on a lower end of the first power structure. The first power structure and the second power structure are integrated as a unitary structure without an interface therebetween, and the first power structure has a first width at an upper thereof and a second width at the lower end thereof, the second width being equal to or greater than the first width.

According to example embodiments, a semiconductor device includes a substrate having an active region extending in a first direction, a gate structure on the active region, intersecting the active region and extending in a second direction, a source/drain region adjacent to the gate structure and on the active region, a contact plug on the source/drain region and electrically connected to the source/drain regions, and a power structure on one side of the source/drain region in the second direction, extending in a third direction that is perpendicular to the first and second directions, electrically connected to the contact plug, and penetrating the substrate. The power structure has a first width on at upper end thereof and a second width at a lower end thereof, the second width being greater than the first width.

At least some of the above and other features of the invention are set out in the claims.

### BRIEF DESCRIPTION OF DRAWINGS

The above and other aspects, features, and advantages of the present inventive concept will be more clearly understood from the following detailed description, taken in conjunction with the accompanying drawings, in which:
FIG. 1 is a plan view illustrating a semiconductor device according to example embodiments;
FIGS. 2A, 2B, and 2C are cross-sectional views illustrating a semiconductor device according to example embodiments;
FIGS. 3A, 3B, and 3C are schematic cross-sectional views illustrating a semiconductor device according to example embodiments;
FIGS. 4A and 4B are schematic cross-sectional views illustrating a semiconductor device according to example embodiments;
FIG. 5 is a schematic cross-sectional view illustrating a semiconductor device according to example embodiments;
FIG. 6 is a schematic cross-sectional view illustrating a semiconductor device according to example embodiments; and
FIGS. 7A to 19B are views illustrating a process sequence to illustrate a method of manufacturing a semiconductor device according to example embodiments. In particular, FIGS. 7A, 8A, 9A, 10A, 11A, 12A, 13A, 14A, 15A, 16A, 17A, 18A, and 19A illustrate cross-sections corresponding to FIG. 2A; FIGS. 7B, 8B, 9B, 10B, 11B, 12B, 13B, 14B, 15B, 16B, 17B, 18B, and 19B illustrate cross-sections corresponding to FIG. 2B; and FIGS. 12C, 13C, 14C, and 15C illustrate cross-sections corresponding to FIG. 2C.

### DETAILED DESCRIPTION

Hereinafter, example embodiments will be described with reference to the accompanying drawings. The terms "comprises," "comprising," "includes" and/or "including," when used herein, specify the presence of stated elements, but do not preclude the presence of additional elements. The term "and/or" includes any and all combinations of one or more of the associated listed items. Hereinafter, terms such as 'on', 'upper', 'upper surface', 'below', 'lower', 'lower surface', 'side' and the like may be understood as referring to the drawings and may be relative to a substrate, except where otherwise indicated by reference numerals. It will be understood that such spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. The terms "first," "second," etc., may be used herein merely to distinguish one component, layer, direction, etc. from another. As used herein, when components or layers are referred to as "directly on" or "directly connected", no intervening components or layers are present.

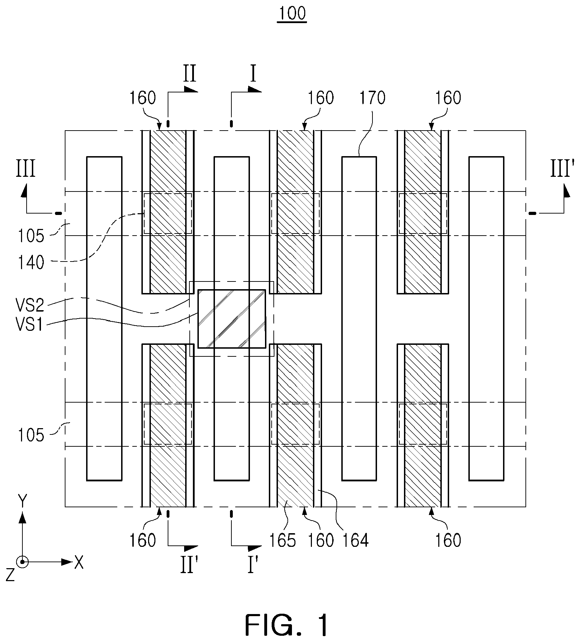

FIG. 1 is a plan view illustrating a semiconductor device according to example embodiments.

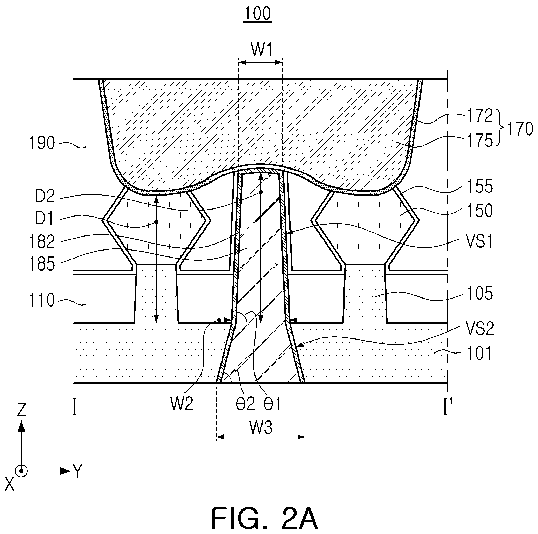

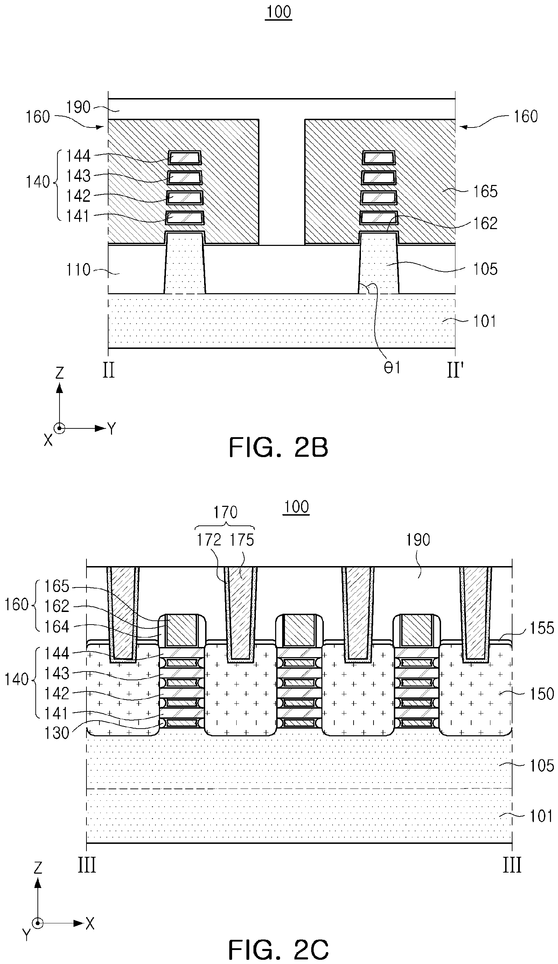

FIGS. 2A to 2C are cross-sectional views illustrating a semiconductor device according to example embodiments. FIGS. 2A, 2B, and 2C illustrate cross-sections of the semiconductor device of FIG. 1 taken along cutting lines I-I', II-II', and III-III', respectively. For convenience of descriptions, only some components of the semiconductor device are illustrated in FIG. 1.

Referring to FIGS. 1 to 2C, a semiconductor device 100 may include a substrate 101 including active regions 105, channel structures 140 including first to fourth channel layers 141, 142, 143, and 144 vertically spaced apart from each other on the active regions 105, gate structures 160 extending across the active regions 105 and respectively including gate electrodes 165, respectively, source/drain regions 150 in contact with the channel structures 140, contact plugs 170 connected to the source/drain regions 150 on the source/drain regions 150, a first power structure VS1 connected to at least one of the contact plugs 170, a second power structure VS2 connected to the first power structure VS1, and a lateral dielectric layer 155 covering surfaces of the source/drain regions 150. The term "connected" may be used herein to refer to a physical and/or electrical connection. The term "surrounding" or "covering" or "filling" as may be used herein may not require completely surrounding or covering or filling the described elements or layers, but may, for example, refer to partially surrounding or covering or filling the described elements or layers. The semiconductor device 100 may further include a device isolation layer 110, inner spacer layers 130, and an interlayer insulating layer 190.

The substrate 101 may have an upper surface extending in the X and Y-directions. The substrate 101 may include a semiconductor material, such as a Group IV semiconductor, a Group III-V compound semiconductor, or a Group II-VI compound semiconductor. For example, the group IV semiconductor may include silicon, germanium, or silicon-germanium. The substrate 101 may be provided as a bulk wafer, an epitaxial layer, a Silicon On Insulator (SOI) layer, or a Semiconductor On Insulator (SeOI) layer.

The substrate 101 may include active regions 105 disposed in an upper portion. However, depending on the description method, the active regions 105 may also be described as a separate configuration from the substrate 101. The active regions 105 may be disposed to extend in a first direction, for example, an X-direction. The active regions 105 may be defined at a predetermined depth from an upper surface in a portion of the substrate 101. The active regions 105 may be formed of a portion of the substrate 101, and may also include an epitaxial layer grown from the substrate 101. Each of the active regions 105 may include active fins protruding upwardly, that is, away from the substrate 101. The active regions 105 together with the channel structures 140 may form an active structure in which a channel region of a transistor is formed. Each of the active regions 105 may include an impurity region. The impurity region may form at least a portion of a well region of a transistor.

The device isolation layer 110 may be positioned between adjacent active regions 105 in the Y-direction. Upper surfaces of the active regions 105 may be located on a higher level than the upper surface of the device isolation layer 110 relative to the substrate 101. The active regions 105 may be partially recessed on both or opposing sides of the gate structures 160, and source/drain regions 150 may be respectively disposed on the recessed regions.

The device isolation layer 110 may fill space between the active regions 105 and define the active regions 105 on the substrate 101. The device isolation layer 110 may be formed by, for example, a shallow trench isolation (STI) process. The device isolation layer 110 may expose (e.g., an entirety of) an upper surface of the active region 105 or may partially expose (e.g., a portion of) an upper surface of the active region 105. The term "exposed" may be used to describe relationships between elements and/or certain intermediate processes in fabricating a completed semiconductor device, but is not intended to necessarily require exposure of the particular region, layer, structure or other element in the completed device. The device isolation layer 110 may be formed of an insulating material. The device isolation layer 110 may include, for example, an oxide, a nitride, or a combination thereof.

The gate structures 160 may be disposed on the active regions 105 to cross the active regions 105 and extend in the second direction, e.g., the Y-direction. Channel regions of transistors may be formed in the active regions 105 crossing the gate electrodes 165 of the gate structures 160 and the channel structure 140. Some of the gate structures 160 may be spaced apart from each other while being disposed on a straight line in or aligned along the Y-direction.

Each of the gate structures 160 may include gate dielectric layers 162, gate spacer layers 164, and the gate electrode 165. In example embodiments, each of the gate structures 160 may further include a capping layer on an upper surface of the gate electrode 165. Alternatively, a portion of the interlayer insulating layer 190 on the gate structures 160 may be referred to as a gate capping layer.

The gate dielectric layers 162 may be disposed between the active region 105 and the gate electrode 165 and between the channel structure 140 and the gate electrode 165, and may be disposed to cover at least portions of the surfaces of the gate electrode 165. For example, the gate dielectric layers 162 may be disposed to surround all surfaces except for an uppermost surface of the gate electrode 165. The gate dielectric layers 162 may extend between the gate electrode 165 and the gate spacer layers 164, but are not limited thereto. The gate dielectric layer 162 may include an oxide, nitride, and/ or high-κ material. The high-κ material may refer to a dielectric material having a higher dielectric constant than a dielectric constant of silicon oxide (SiO₂). The high-κ material may be any one of, for example, aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). According to example embodiments, the gate dielectric layer 162 may have a multilayer structure.

The gate electrode 165 may include a conductive material, and for example, may include a metal nitride such as titanium nitride (TiN), tantalum nitride (TaN), or tungsten nitride (WN), and/or a metal such as aluminum (Al), tungsten (W), or molybdenum (Mo), or a semiconductor material such as doped polysilicon. According to example embodiments, the gate electrode 165 may have a multilayer structure.

The gate spacer layers 164 may be disposed on both or opposing side surfaces of the gate electrode 165, on the channel structure 140. The gate spacer layers 164 may insulate the source/drain regions 150 and the gate electrodes 165. Depending on example embodiments, the shape of upper ends of the gate spacer layers 164 may vary, and the gate spacer layers 164 may have a multilayer structure. For example, each of the gate spacer layers 164 may include an outermost layer extending from the lateral dielectric layer 155. The gate spacer layers 164 may include at least one of oxide, nitride, and oxynitride, and may be formed of, for example, a low-κ film.

The channel structures 140 may be disposed on the active regions 105, in regions in which the active regions 105 intersect the gate structures 160. Each of the channel structures 140 may include first to fourth channel layers 141, 142, 143, and 144, that is, two or more channel layers spaced apart from each other in the Z-direction. The channel structures 140 may be connected to the source/drain regions 150. The channel structures 140 may have a width or other dimension equal to or less than a width of the active region 105 in the Y-direction, and may have a width or other dimension equal to or similar to a width of the gate structures 160 in the X-direction. In a cross section in the Y-direction, a lower channel layer among the first to fourth channel layers 141, 142, 143, and 144 may have a width equal to or larger than a width of the upper channel layer. In some embodiments, the channel structures 140 may have a reduced width, as compared to the gate structures 160, such that side surfaces thereof are located below the gate structures 160 in the X-direction.

The channel structures 140 may be formed of a semiconductor material, and may include, for example, at least one of silicon (Si), silicon germanium (SiGe), and germanium (Ge). The channel structures 140 may be made of, for example, the same material as the active regions 105. The number and shape of channel layers constituting one channel structure 140 may vary in example embodiments.

In the semiconductor device 100, the gate electrode 165 may be disposed between the active region 105 and the channel structures 140, between the first to fourth channel layers 141, 142, 143, and 144 of the channel structures 140, and on the channel structures 140. Accordingly, the semiconductor device 100 may include a transistor of a Multi Bridge Channel FET (MBCFET^{™}) structure, which is a gate-all-around type field effect transistor. However, in some embodiments, the semiconductor device 100 may not include the channel structures 140 and for example, may have a FinFET structure.

The source/drain regions 150 may be disposed to contact the channel structures 140 on both or opposing sides of the gate structures 160, respectively. The source/drain regions 150 may be disposed in regions in an upper portion of the active region 105 that is partially recessed. As illustrated in FIG. 2A, at least a portion of the source/drain regions 150 may be electrically connected to the second power structure VS2 through the contact plug 170 and the first power structure VS1, and may receive power applied from the second power structure VS2.

Upper surfaces of the source/drain regions 150 may be positioned on the same or similar level as lower surfaces of the gate structures 160 on the channel structures 140, but the level of the upper surfaces of the source/drain regions 150 may vary in example embodiments relative to the substrate 101. The source/drain regions 150 may have a polygonal shape or an elliptical shape as illustrated in FIG. 2A in a cross section in the Y-direction, but the present inventive concept is not limited to the illustrated shapes. The source/drain regions 150 may include a semiconductor material, for example, silicon (Si) and/or germanium (Ge), and may further include impurities.

The inner spacer layers 130 may be disposed parallel to the gate electrode 165, and between the first to fourth channel layers 141, 142, 143, and 144 in the Z-direction. The gate electrode 165 is stably or sufficiently spaced apart from the source/drain regions 150 by the inner spacer layers 130 and may be electrically isolated. The inner spacer layers 130 may have a shape in which a side surface facing the gate electrode 165 is convexly rounded toward the gate electrode 165, but the present inventive concept is not limited thereto. The inner spacer layers 130 may include at least one of oxide, nitride, and oxynitride, and may be formed of, for example, a low-κ film. However, in some embodiments, the inner spacer layers 130 may be omitted.

The contact plugs 170 may be disposed on the source/drain regions 150. The contact plugs 170 may pass through the interlayer insulating layer 190 and be connected to the source/drain regions 150. The contact plugs 170 may have side surfaces that are inclined to decrease in width toward the substrate 101 due to an aspect ratio, but the present inventive concept is not limited thereto. Lower ends of the contact plugs 170 may be positioned on a level higher than the level of lower ends of the source/drain regions 150. The contact plugs 170 may partially recess the source/drain regions 150 and may be disposed to contact portions of surfaces including upper surfaces of the source/drain regions 150. As illustrated in FIG. 2A, the contact plug 170 may be disposed to connect adjacent source/drain regions 150 together in the Y-direction. However, in example embodiments, the form in which the contact plugs 170 are connected to the source/drain regions 150 may vary. Separate gate contact plugs may be further disposed on the gate electrodes 165 in regions not illustrated.

Each of the contact plugs 170 may include a contact barrier layer 172 forming side and lower surfaces and a contact conductive layer 175 on the contact barrier layer 172. The contact barrier layer 172 covers an upper surface of the first power structure VS1 and may directly contact the first power structure VS1. In some embodiments, each of the contact plugs 170 may further include a metal-semiconductor compound layer, for example, a metal silicide layer, forming a lower surface. The contact barrier layer 172 may include, for example, a metal nitride such as titanium nitride (TiN), tantalum nitride (TaN), or tungsten nitride (WN). The contact conductive layer 175 may include a metal material such as, for example, aluminum (Al), tungsten (W), or molybdenum (Mo). In example embodiments, the number and arrangement of conductive layers constituting the contact plugs 170 may vary.

The first power structure VS 1 may be disposed to connect at least one of the contact plugs 170 and the second power structure VS2. As illustrated in FIG. 2A, the first power structure VS1 may be disposed to extend in a third direction, for example, a Z-direction, between adjacent source/drain regions 150 in the Y-direction. The first power structure VS1 may be disposed to pass through the interlayer insulating layer 190 and the device isolation layer 110.

As illustrated in FIG. 1, the first power structure VS1 may have a quadrangular shape on a plan view, but is not limited thereto. In some embodiments, the first power structure VS1 may have an elliptical or circular shape in plan view. In some embodiments, the first power structure VS1 may be disposed to extend in the X-direction, between adjacent gate structures 160 in the Y-direction.

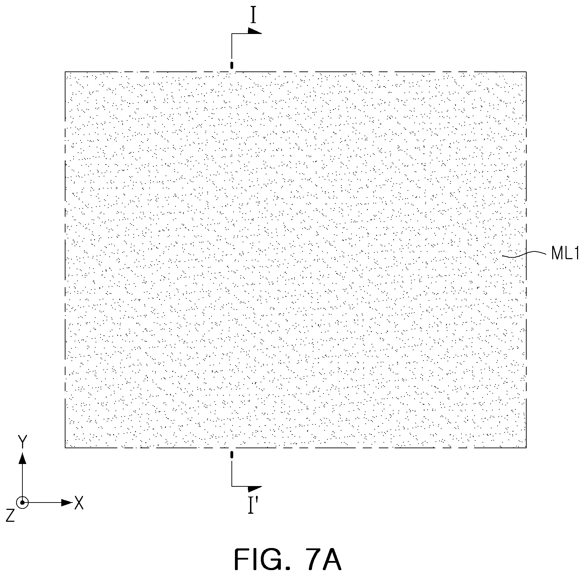

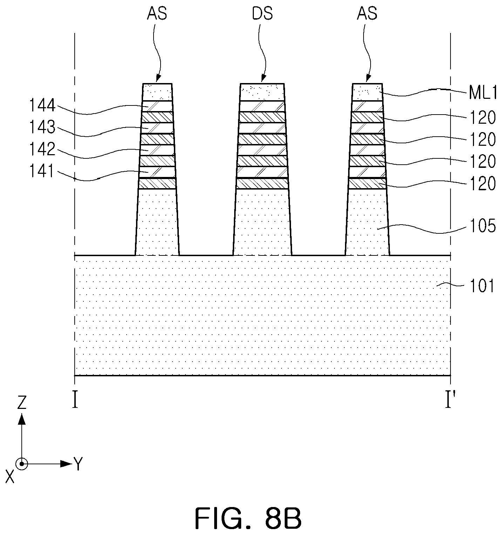

The first power structure VS 1 may have an inclined side surface such that the width thereof increases toward the substrate 101. In the first power structure VS1 of this embodiment, a first width W1 at an upper end may be less than a second width W2 at a lower end. The side of the first power structure VS1 may have a first slope θ1 relative to a horizontal line, for example, a lower surface of the substrate 101, and this slope may be substantially the same as the slope of the side of the active region 105. In this embodiment, the first slope 01 may be less than 90 degrees. The shape of the first power structure VS1 may be formed because the first power structure VS1 is manufactured using a dummy channel structure DS (see FIG. 8B ) including the first to fourth channel layers 141, 142, 143, and 144, which will be described in more detail with reference to FIGS. 7A to 19B below.

The first power structure VS1 may be connected to the contact plug 170 through an upper end or an upper surface and connected to the second power structure VS2 through a lower end or a lower surface. The upper end of the first power structure VS 1 may be positioned on a level higher than a level of upper ends of the source/drain regions 150 relative to the substrate 101. A height D1 from a lower surface of the active region 105 to an upper end of the center of the source/drain regions 150 may be less than a height D2 from the lower surface of the active region 105 to the upper end of the center of the first power structure VS1. At least a portion of the first power structure VS1 may be positioned at a level overlapping the source/drain regions 150. Components or layers described with reference to "overlap" in a particular direction may be at least partially obstructed by one another when viewed along a line extending in the particular direction or in a plane perpendicular to the particular direction. For example, the first power structure VS1 may overlap the source/drain regions 150 in the Y-direction. The lower end of the first power structure VS1 may be positioned at a level lower than a level of a lower surfaces of the source/drain regions 150, and may be located at a level lower than the levels of upper surfaces of the active regions 105 relative to the substrate 101. The lower end of the first power structure VS1 may be located at a level higher than the level of the lower surface of the substrate 101.

The second power structure VS2 may pass through the substrate 101 and be connected to the lower surface of the first power structure VS1. The second power structure VS2 may be connected to a separate power interconnection line disposed below the lower surface of the substrate 101.

As illustrated in FIG. 1, the second power structure VS2 may have a quadrangular shape on a plan view, but is not limited thereto. In some embodiments, the second power structure VS2 may have an elliptical or circular shape in plan view. In some embodiments, the second power structure VS2 may have a line or linear shape extending in the X-direction or the Y-direction.

The second power structure VS2 may have an inclined side surface such that the width thereof decreases toward the upper surface of the substrate 101 or the upper surfaces of the active regions 105. In the second power structure VS2, the second width W2 of an upper end may be less than a third width W3 of a lower end, and may be equal to the width W2 of the lower end of the first power structure VS1. The side of the second power structure VS2 may have a second slope Θ2 relative to a horizontal line, for example, the lower surface of the substrate 101, and this second slope Θ2 may be different from the first slope θ1 of the first power structure VS 1. For example, the second slope Θ2 may be less than the first slope 01. Accordingly, a bent portion may be formed between the first power structure VS1 and the second power structure VS2 according to a change in side slope. In some embodiments, an insulating liner layer may be further disposed between the second power structure VS2 and the substrate 101.

The first power structure VS1 and the second power structure VS2 may be integrally formed as a unitary structure and collectively referred to as a power structure. There may be no interface between the first power structure VS 1 and the second power structure VS2. For example, the first power structure VS1 and the second power structure VS2 may not be distinguished by material layers constituting the first power structure VS1 and the second power structure VS2. The power structure may include a vertical barrier layer 182 and a vertical conductive layer 185. The vertical barrier layer 182 may be disposed to form a side surface of the second power structure VS2 and a side surface and an upper surface of the first power structure VS1. The vertical barrier layer 182 may continuously extend between a side surface of the first power structure VS1 and a side surface of the second power structure VS2. The vertical conductive layer 185 may be disposed on lower and side surfaces of the vertical barrier layer 182. The term "vertical" includes extending predominantly in, for example, the Z direction away from tne substrate.

The vertical barrier layer 182 may include a metal nitride such as, for example, titanium nitride (TiN), tantalum nitride (TaN), or tungsten nitride (WN). The vertical conductive layer 185 may include a conductive material, for example, a metal such as molybdenum (Mo), aluminum (Al), or tungsten (W).

The lateral dielectric layer 155 may cover exposed surfaces of the source/drain regions 150 and may conformally extend along the upper surface of the device isolation layer 110 to cover a portion of the side surface of the first power structure VS1. The lateral dielectric layer 155 may be interposed between the source/drain regions 150 and the interlayer insulating layer 190. As illustrated in FIG. 2A, the lateral dielectric layer 155 may extend horizontally along an upper surface of the device isolation layer 110, and may cover the side surface of the first power structure VS1 on the device isolation layer 110 and extend upwardly relative to the substrate 101.

The lateral dielectric layer 155 may include at least one of oxide, nitride, and oxynitride, and may include, for example, a low-κ material. The lateral dielectric layer 155 may include a plurality of dielectric layers, and for example, may include low-κ material layer, for example, a SiOCN layer, and a SiN layer, sequentially stacked from the source/drain regions 150.

The interlayer insulating layer 190 may be disposed to cover the source/drain regions 150 and the gate structures 160. The interlayer insulating layer 190 may include at least one of oxide, nitride, and oxynitride, and may include, for example, a low-κ material. According to example embodiments, the interlayer insulating layer 190 may include a plurality of insulating layers.

The semiconductor device 100 may be packaged by inverting the structure of FIGS. 2A to 2C such that the second power structure VS2 is located on the upper portion, but the packaging form of the semiconductor device 100 is not limited thereto. Since the semiconductor device 100 includes the second power structure VS2 disposed below the source/drain regions 150, integration may be improved.

In addition, since the first power structure VS 1 has a structure in which the width increases toward the substrate 101, contact resistance with the second power structure VS2 may be improved. Since the second power structure VS2 has a self-aligned structure with the first power structure VS1, reliability may be secured.

In the description of the following embodiments, descriptions overlapping with those described above with reference to FIGS. 1 to 2C will be omitted.

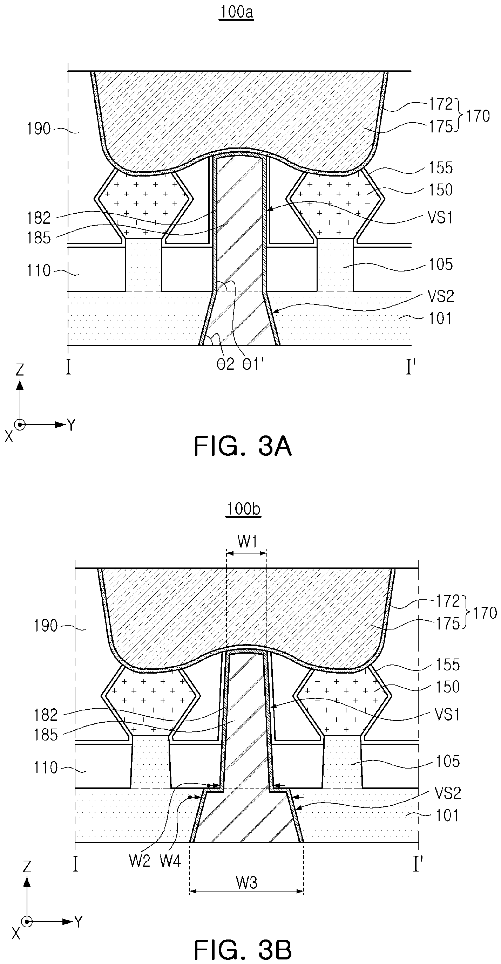

FIGS. 3A to 3C are schematic cross-sectional views illustrating a semiconductor device according to example embodiments. FIGS. 3A to 3C illustrate regions corresponding to FIG. 2A.

Referring to FIG. 3A, in a semiconductor device 100a, a first slope θ1' of a side surface of the first power structure VS1 may be different from that in the example embodiment of FIG. 2A. In this embodiment, a first slope 01' may be substantially equal to 90 degrees and may be greater than a second slope Θ2 of the side surface of the second power structure VS2. Side surfaces of the active regions 105 may also have slopes substantially equal to 90 degrees with respect to the lower surface of the substrate 101, but are not limited thereto. A width of the lower end of the first power structure VS1 may be substantially the same as a width of the upper end of the first power structure VS1. As such, in example embodiments, the slope of the side surface of the first power structure VS1 may vary within a range in which the width of the lower end of the first power structure VS1 does not become smaller than the width of the upper end of the first power structure VS1.

Referring to FIG. 3B, in a semiconductor device 100b, a fourth width W4 of the upper end of the second power structure VS2 may be different from the second width W2 of the lower end of the first power structure VS 1. In this embodiment, the fourth width W4 may be greater than the second width W2 and smaller than the third width W3 of the lower end of the second power structure VS2. Accordingly, the width may be discontinuously changed between the first power structure VS1 and the second power structure VS2, and thus a step may be formed. The vertical barrier layer 182 and the vertical conductive layer 185 may include a region extending horizontally between the first power structure VS1 and the second power structure VS2 by the step.

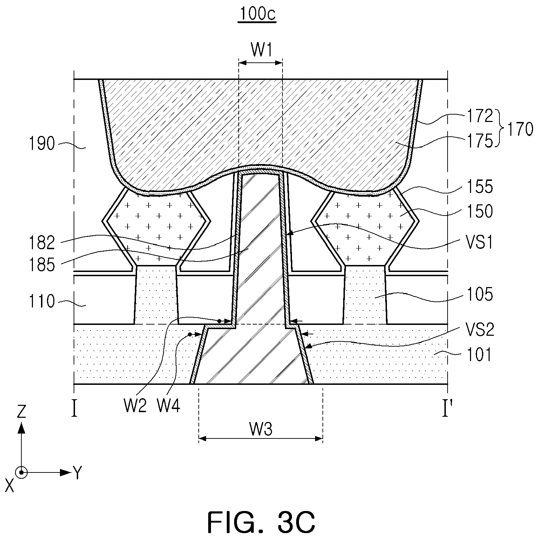

Referring to FIG. 3C, in a semiconductor device 100c, the fourth width W4 of the upper end of the second power structure VS2 may be greater than the second width W2 of the lower end of the first power structure VS1, as in the example embodiment of FIG. 3B. However, in this embodiment, the center vertical axis of the second power structure VS2 may be shifted or offset from the center vertical axis of the first power structure VS1.

This structure may be, for example, a structure formed while the second power structure VS2 is misaligned with respect to the first power structure VS1 during the manufacturing process of the semiconductor device 100c. However, even in this case, the second power structure VS2 may be self-aligned and integrally formed with the first power structure VS1, and thus, may be stably and reliably connected to each other.

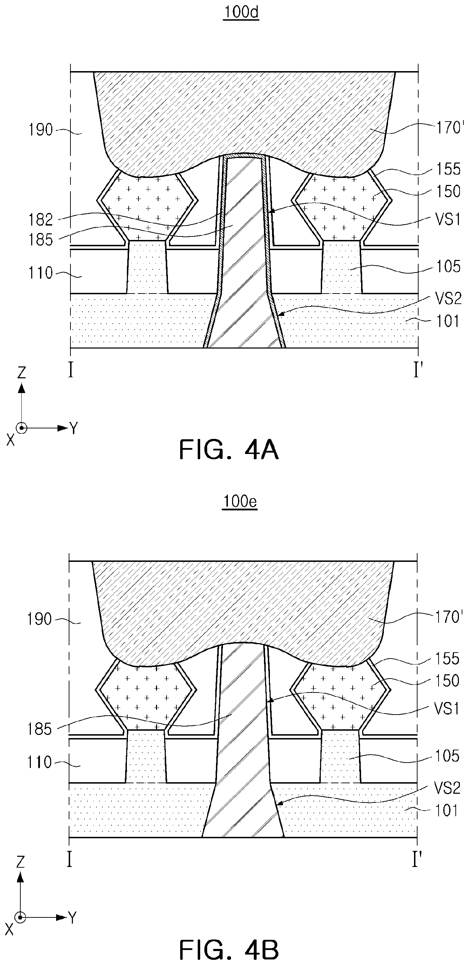

FIGS. 4A and 4B are schematic cross-sectional views illustrating a semiconductor device according to example embodiments. FIGS. 4A and 4B illustrate the region corresponding to FIG. 2A.

Referring to FIG. 4A, in a semiconductor device 100d, a contact plug 170' may not include the contact barrier layer 172 (see FIG. 2A). Accordingly, in the contact plug 170', a conductive layer corresponding to the contact conductive layer 175 of FIG. 2A may directly contact the vertical barrier layer 182 of the first power structure VS1.

Referring to FIG. 4B, in a semiconductor device 100e, the contact plug 170' does not include the contact barrier layer 172 (see FIG. 2A) as in the example embodiment of FIG. 4A, and unlike the example embodiment of FIG. 4A, the first power structure VS1 and the second power structure VS2 may also not include the vertical barrier layer 182. Accordingly, in the contact plug 170', the conductive layer corresponding to the contact conductive layer 175 of FIG. 2A may directly contact the vertical conductive layer 185.

As such, in example embodiments, in the contact plug 170' and the power structure including the first power structure VS1 and the second power structure VS2, whether or not the barrier layer is included may vary. In some embodiments, the contact plug 170 may include the contact barrier layer 172 as in FIG. 2A, and the power structure may not include the vertical barrier layer 182. That is, one or more of the barrier layers 172, 182 may be optional in some embodiments.

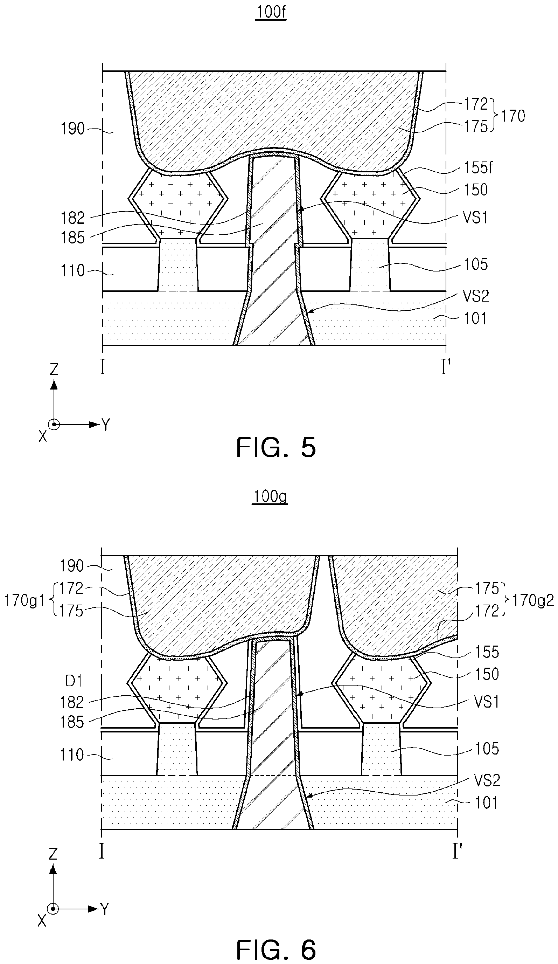

FIG. 5 is a schematic cross-sectional view illustrating a semiconductor device according to example embodiments. FIG. 5 illustrates the region corresponding to FIG. 2A.

Referring to FIG. 5, in a semiconductor device 100f, a dielectric layer 155f does not extend along the side surface of the first power structure VS1. The dielectric layer 155fmay cover surfaces of the source/drain regions 150 and may extend along the upper surface of the device isolation layer 110 to contact the side surface of the first power structure VS 1, but does not extend upwardly along the side surface of the first power structure VS1. The width of the first power structure VS1 at its lower end (at the same height as the upper surface of the substrate 101) is at least as wide as the width at the upper end thereof.

In this embodiment, the width of the first power structure VS1 may be changed (i.e., increased) by a thickness of the dielectric layer 155f in a region that was in contact with the dielectric layer 155f. In previous embodiments (i.e., due to the absence of the dielectric layer 155f on the side surfaces of the first power structure VS1 in the embodiment of FIG. 5, as compared to embodiments where the dielectric layer 155f is present on the side surfaces). The first power structure VS1 may have a shape in which a width is expanded by the thickness of the dielectric layer 155f on a region in contact with the dielectric layer 155f in previous embodiments.

FIG. 6 is a schematic cross-sectional view illustrating a semiconductor device according to example embodiments. FIG. 6 illustrates the region corresponding to FIG. 2A.

Referring to FIG. 6, in a semiconductor device 100g, the arrangement form of contact plugs 170g1 and 170g2 may be different from that of the example embodiment of FIG. 2A. The contact plugs 170g1 and 170g2 may be respectively disposed in adjacent source/drain regions 150 in the Y-direction. Accordingly, the first power structure VS1 may be electrically connected to one source/drain region 150 through the contact plug 170g1. Similarly, other source/drain regions 150 may be connected to the first power structure VS1 through the contact plug 170g2, but the present inventive concept is not limited thereto.

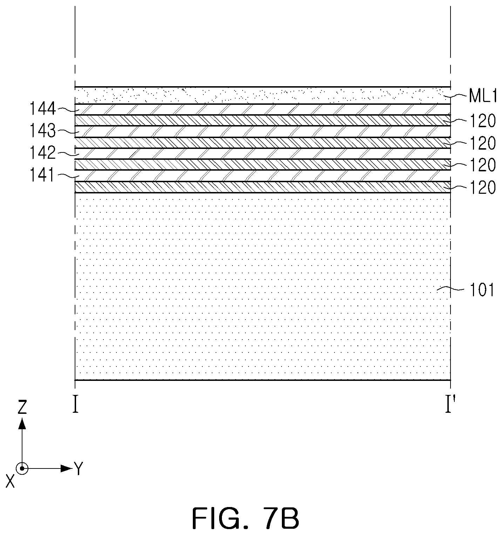

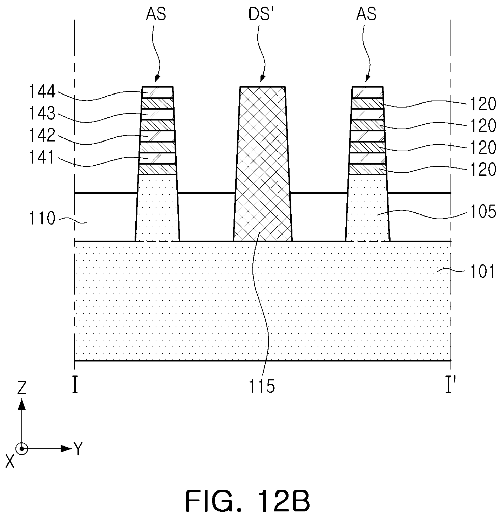

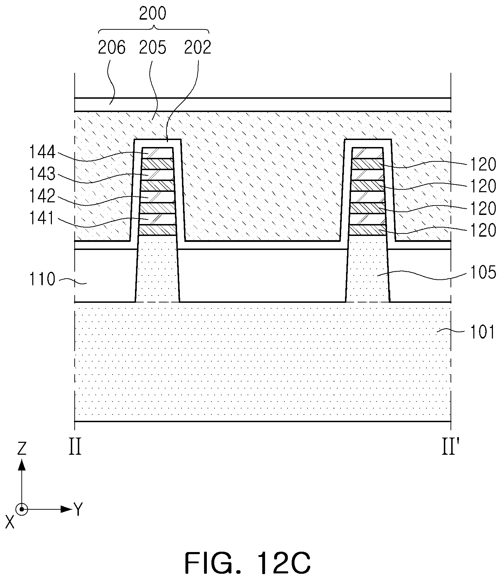

FIGS. 7A to 19B are views illustrating a process sequence to describe a method of manufacturing a semiconductor device according to example embodiments. FIGS. 7A to 19B describe an example embodiment of a method of manufacturing the semiconductor device of FIGS. 1 to 2C. FIGS. 7A, 8A, 9A, 10A, 11A, 12A, 13A, 14A, 15A, 16A, 17A, 18A, and 19A illustrate cross-sections corresponding to FIG. 2A. FIGS. 7B, 8B, 9B, 10B, 11B, 12B, 13B, 14B, 15B, 16B, 17B, 18B, and 19B illustrate cross-sections corresponding to FIG. 2B. FIGS. 12C, 13C, 14C, and 15C illustrate cross-sections corresponding to FIG. 2C.

Referring to FIGS. 7A and 7B, horizontal sacrificial layers 120 and first to fourth channel layers 141, 142, 143, and 144 may be alternately formed on the substrate 101, and a first mask layer ML1 may be formed.

The horizontal sacrificial layers 120 may be replaced with the gate dielectric layers 162 and the gate electrode 165 below the fourth channel layer 144 through subsequent processes, as illustrated in FIGS. 2B and 2C. The horizontal sacrificial layers 120 may be formed of a material respectively having etch selectivity with respect to the first to fourth channel layers 141, 142, 143, and 144. The first to fourth channel layers 141, 142, 143, and 144 may include a material different from the material of the horizontal sacrificial layers 120. The horizontal sacrificial layers 120 and the first to fourth channel layers 141, 142, 143, and 144 may include a semiconductor material including at least one of, for example, silicon (Si), silicon germanium (SiGe), and germanium (Ge), but may include different materials, and may or may not contain impurities. For example, the horizontal sacrificial layers 120 may include silicon germanium (SiGe), and the first to fourth channel layers 141, 142, 143, and 144 may include silicon (Si).

The horizontal sacrificial layers 120 and the first to fourth channel layers 141, 142, 143, and 144 may be formed by performing an epitaxial growth process on the substrate 101. The number of layers of the channel layers 141, 142, 143, and 144 alternately stacked with the horizontal sacrificial layers 120 may vary in example embodiments.

The first mask layer ML1 may be, for example, a hard mask layer, and may be formed on the fourth channel layer 144, for a subsequent process.

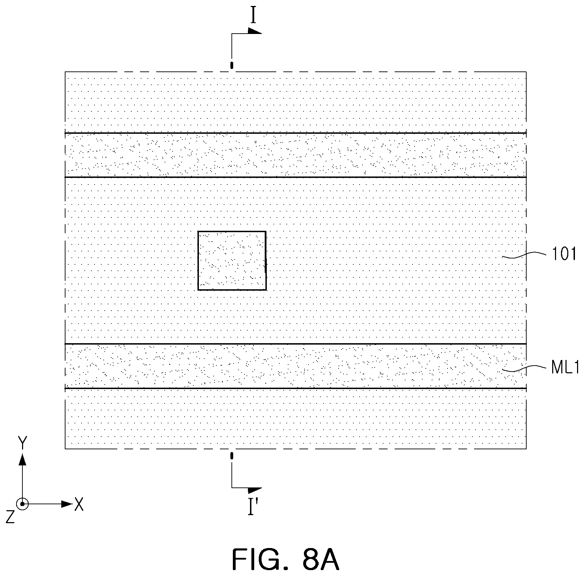

Referring to FIGS. 8A and 8B, active structures AS and dummy channel structures DS including active regions 105 may be formed.

The active structures AS and the dummy channel structure DS may be formed by patterning the horizontal sacrificial layers 120, the first to fourth channel layers 141, 142, 143, and 144, and the upper region of the substrate 101, using the first mask layer ML1. The active structures AS and the dummy channel structure DS may include horizontal sacrificial layers 120 and first to fourth channel layers 141, 142, 143, and 144, which are alternately stacked with each other, and may further include active regions 105 that is formed to protrude from the substrate 101 by removing a portion of the substrate 101.

As illustrated in FIG. 8A, the active structures AS may be formed in a line or linear shape extending in one direction, for example, the X-direction, and may be spaced apart from each other in the Y-direction. The dummy channel structure DS may be formed in a region corresponding to the first power structure VS1 (see FIGS. 1 and 2A). In the Y-direction, the width of the dummy channel structure DS may be greater than the width of the active structures AS, but the present inventive concept is not limited thereto. In this embodiment, depending on the aspect ratio, the side surfaces of the active structures AS and the side surfaces of the dummy channel structure DS may have an inclined shape such that the width increases while facing downwardly, that is, towards the substrate 101. In the case of the example embodiment of FIG. 3A, in this operation, the side surfaces of the active structures AS and the side surfaces of the dummy channel structure DS may be formed to have a vertical shape.

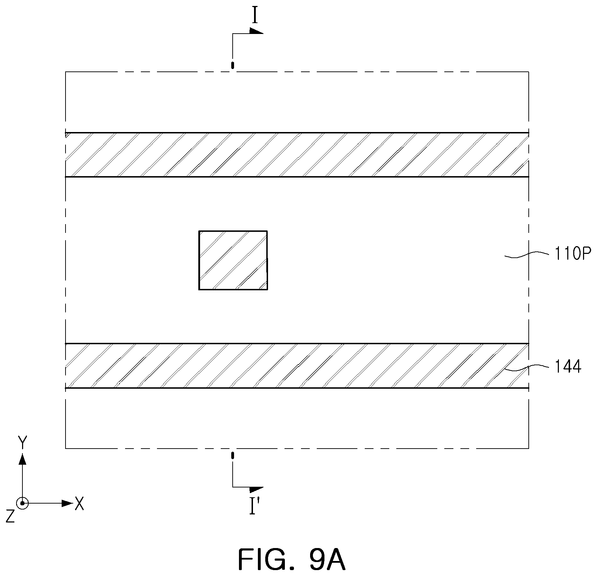

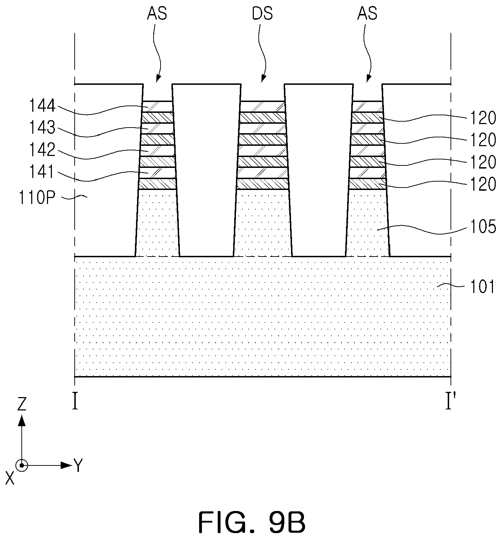

Referring to FIGS. 9A and 9B, a preliminary device isolation layer 110P is formed between the active structures AS and the dummy channel structure DS, and the first mask layer ML1 may be removed.

The preliminary device isolation layer 110P may be formed by filling the space between the active structures AS and the dummy channel structure DS with an insulating material. After forming the preliminary device isolation layer 110P, the first mask layer ML1 may be removed.

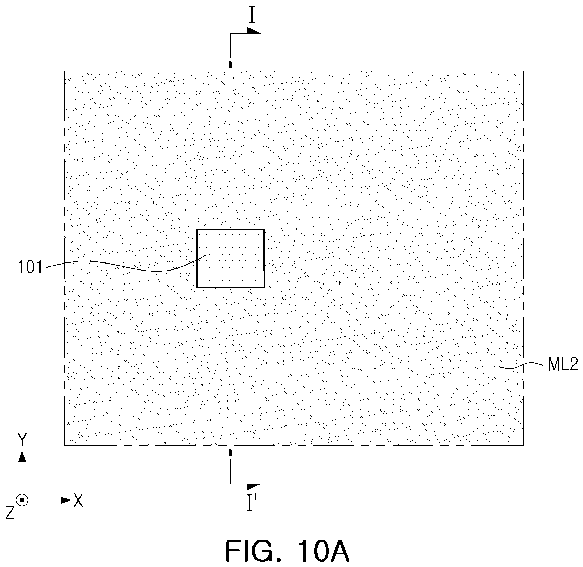

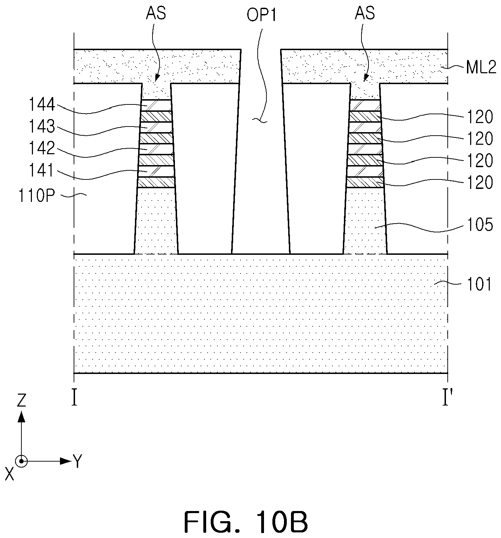

Referring to FIGS. 10A and 10B, a second mask layer ML2 may be formed and the dummy channel structure DS may be removed.

The second mask layer ML2 may be formed to expose the dummy channel structure DS. The exposed dummy channel structure DS may be removed through an etching process. Accordingly, a first opening OP1 may be formed in the region in which the dummy channel structure DS has been removed. Afterwards, the second mask layer ML2 may be removed.

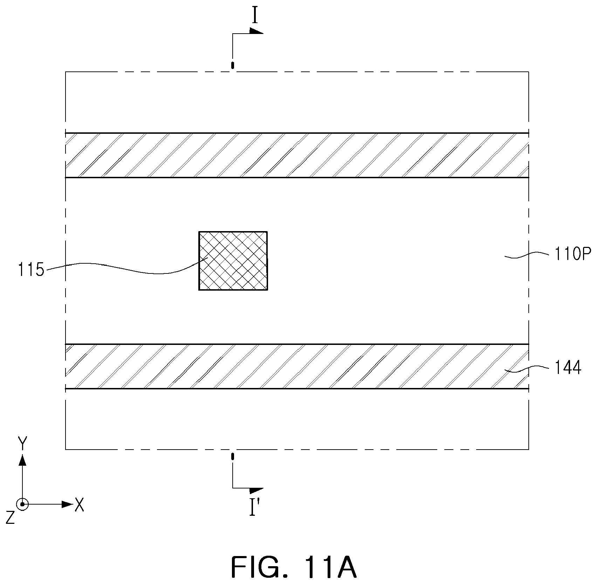

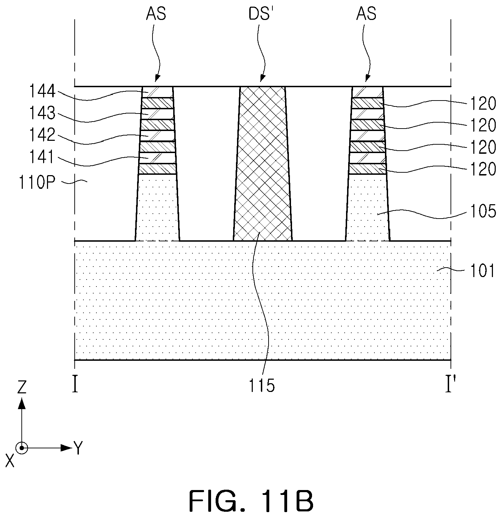

Referring to FIGS. 11A and 11B, a vertical sacrificial layer 115 may be formed in the first opening OP1 to form a dummy vertical structure DS'.

The vertical sacrificial layer 115 may include a material different from a material of the preliminary device isolation layer 110P, and for example, may include silicon nitride. After filling the first opening OP1 with the vertical sacrificial layer 115, a planarization process may be performed. The vertical sacrificial layer 115 may form the dummy vertical structure DS'.

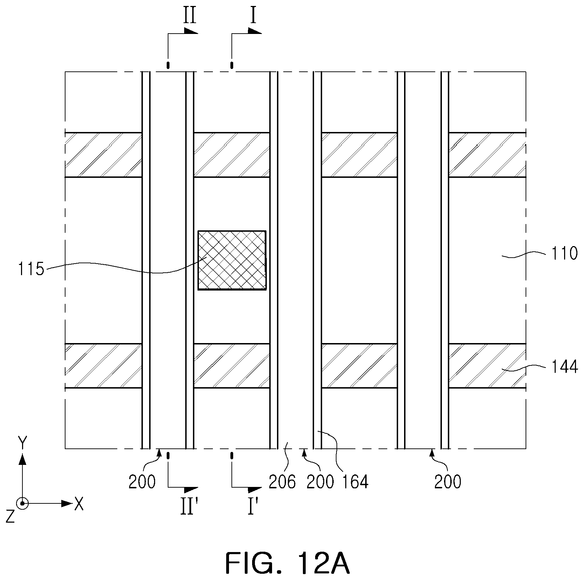

Referring to FIGS. 12A to 12C, a device isolation layer 110 may be formed, and a sacrificial gate structure 200 and gate spacer layers 164 may be formed on the active structures AS.

The device isolation layer 110 may be formed by partially recessing the preliminary device isolation layer 110P. An upper surface of the device isolation layer 110 may be positioned at a lower level than upper surfaces of the active regions 105 relative to the substrate 101. The active structures AS and the dummy vertical structure DS' may protrude onto the device isolation layer 110.

The sacrificial gate structures 200 may be a sacrificial structure formed in a region on the channel structures 140, in which the gate dielectric layer 162 and the gate electrode 165 are disposed through subsequent processes as illustrated in FIGS. 2B and 2C. The sacrificial gate structures 200 may have a line or linear shape extending in one direction while crossing the active structures AS. As illustrated in FIG. 12A, the sacrificial gate structures 200 may extend in, for example, the Y-direction and be spaced apart from each other in the X-direction.

The sacrificial gate structure 200 may include first and second sacrificial gate layers 202 and 205 and a mask pattern layer 206, sequentially stacked. The first and second sacrificial gate layers 202 and 205 may be patterned using the mask pattern layer 206. The first and second sacrificial gate layers 202 and 205 may be an insulating layer and a conductive layer, respectively, but are not limited thereto. The first and second sacrificial gate layers 202 and 205 may be formed of one layer. For example, the first sacrificial gate layer 202 may include silicon oxide, and the second sacrificial gate layer 205 may include polysilicon. The mask pattern layer 206 may include silicon oxide and/or silicon nitride.

Gate spacer layers 164 may be formed on both or opposing sidewalls of the sacrificial gate structures 200. The gate spacer layers 164 may be formed of a low-κ material, and for example, may include at least one of SiO, SiN, SiCN, SiOC, SiON, and SiOCN.

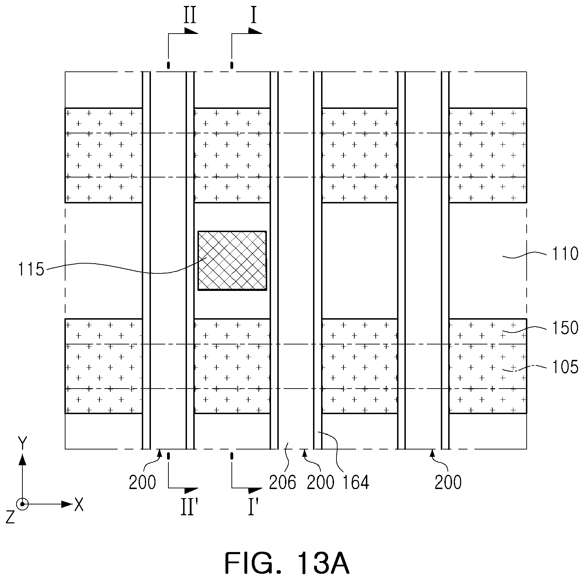

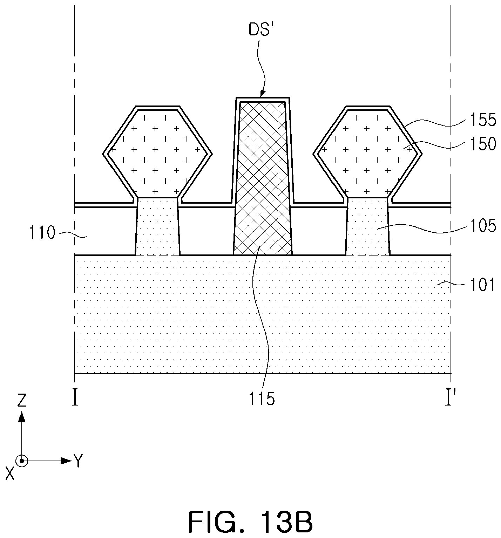

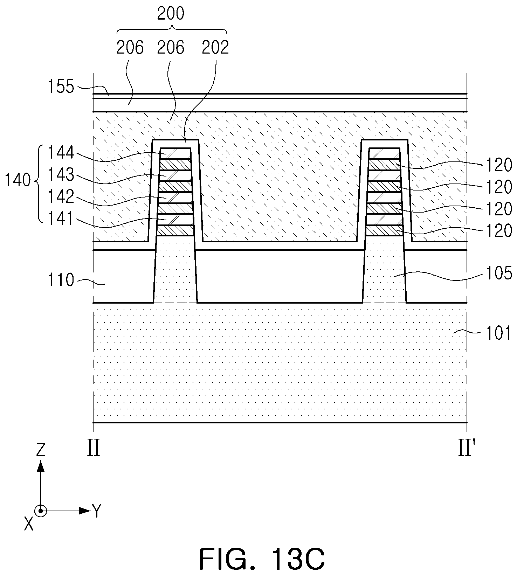

Referring to FIGS. 13A to 13C, source/drain regions 150 and a lateral dielectric layer 155 may be formed. For ease of understanding, the lateral dielectric layer 155 is omitted in FIG. 13A.

First, recess regions may be formed by removing exposed portions of the horizontal sacrificial layers 120 and the first to fourth channel layers 141, 142, 143, and 144, using the sacrificial gate structures 200 and the gate spacer layers 164 as masks. In this operation, the first to fourth channel layers 141, 142, 143, and 144 may form channel structures 140 having a limited length in the X-direction. Next, the horizontal sacrificial layers 120 exposed through the recess regions may be partially removed from the side surfaces, and the inner spacer layers 130 of FIG. 2C may be formed.

The source/drain regions 150 are formed in the recess regions and may be formed by growing from side surfaces of the active regions 105 and the channel structures 140 by, for example, a selective epitaxial process. The source/drain regions 150 may include impurities by in-situ doping, and may include a plurality of layers having different doping elements and/or doping concentrations.

The lateral dielectric layer 155 may be conformally formed on the entire fabricated structure. The lateral dielectric layer 155 may be, for example, a bi-layer of a low-κ material and silicon nitride. Portions of the lateral dielectric layer 155 may form gate spacer layers 164.

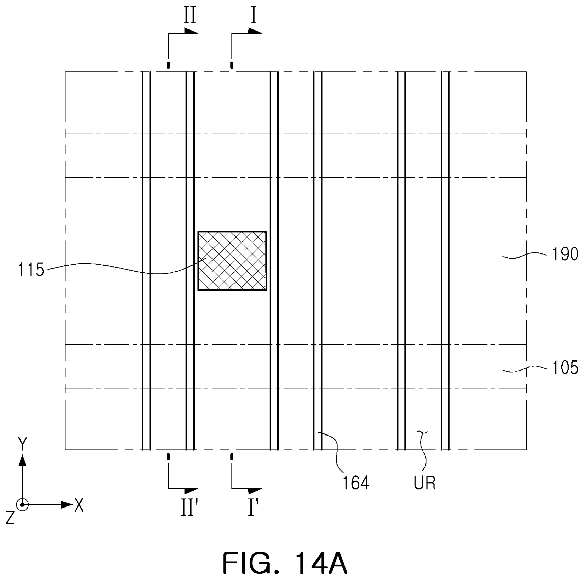

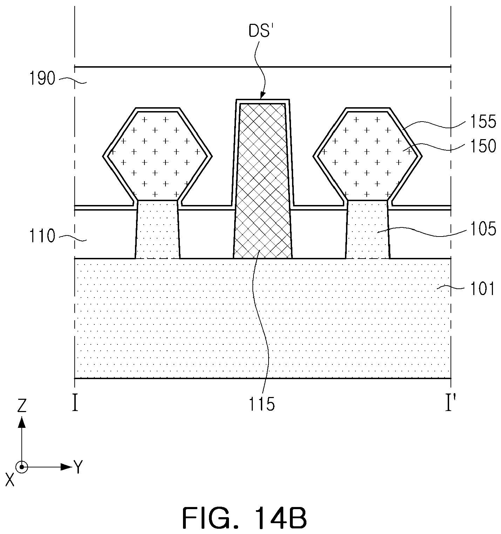

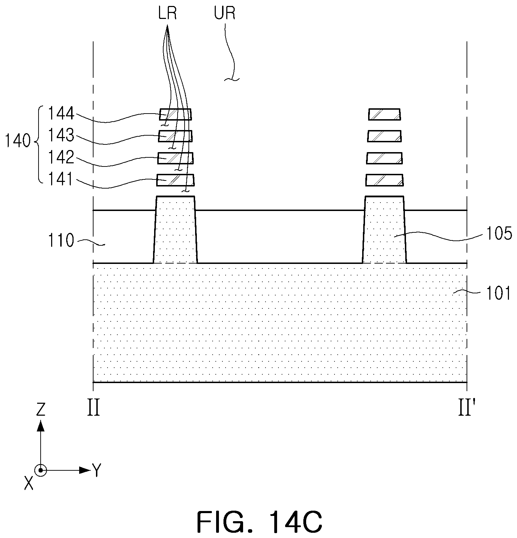

Referring to FIGS. 14A to 14C, the interlayer insulating layer 190 may be partially formed, and the horizontal sacrificial layers 120 and the sacrificial gate structures 200 may be removed.

The interlayer insulating layer 190 may be formed by forming an insulating film covering the sacrificial gate structures 200 and the source/drain regions 150 and performing a planarization process.

The horizontal sacrificial layers 120 and the sacrificial gate structures 200 may be selectively removed with respect to the gate spacer layers 164, the interlayer insulating layer 190, the channel structures 140, and the inner spacer layers 130 (see FIG. 2C). First, after the sacrificial gate structures 200 are removed to form upper gap regions UR, lower gap regions LR may be formed by removing the horizontal sacrificial layers 120 exposed through the upper gap regions UR. During the removal process, the source/drain regions 150 may be protected by the interlayer insulating layer 190 and the inner spacer layers 130.

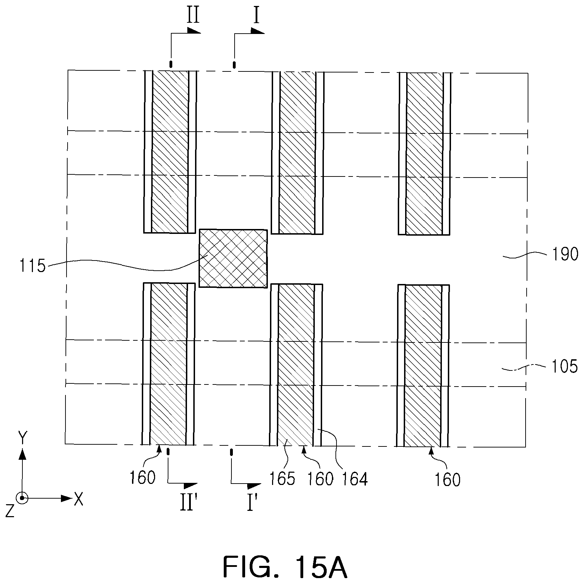

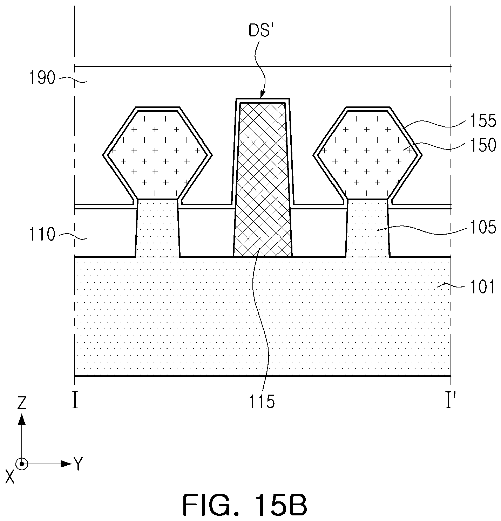

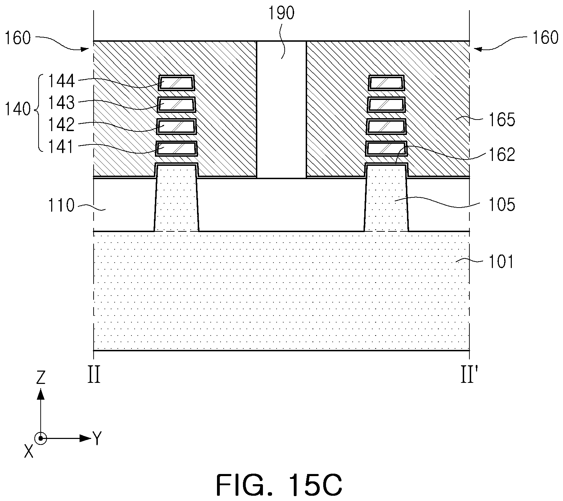

Referring to FIGS. 15A to 15C, gate structures 160 may be formed by forming gate dielectric layers 162 and a gate electrode 165.

The gate dielectric layers 162 and the gate electrode 165 may be formed to fill the upper gap regions UR and lower gap regions LR. The gate dielectric layers 162 may be formed to conformally cover inner surfaces of the upper gap regions UR and the lower gap regions LR. After the gate electrode 165 is formed to completely fill the upper gap regions UR and lower gap regions LR, the gate electrode 165 may be removed from an upper portion of the upper gap regions UR to a predetermined depth, together with the gate dielectric layers 162 and the gate spacer layers 164.

The gate dielectric layers 162, the gate electrode 165, and the gate spacer layers 164 are formed to continuously extend in the Y-direction, and may then be removed in some regions by an etching process. Accordingly, the gate structures 160 separated from each other in the Y-direction may be formed.

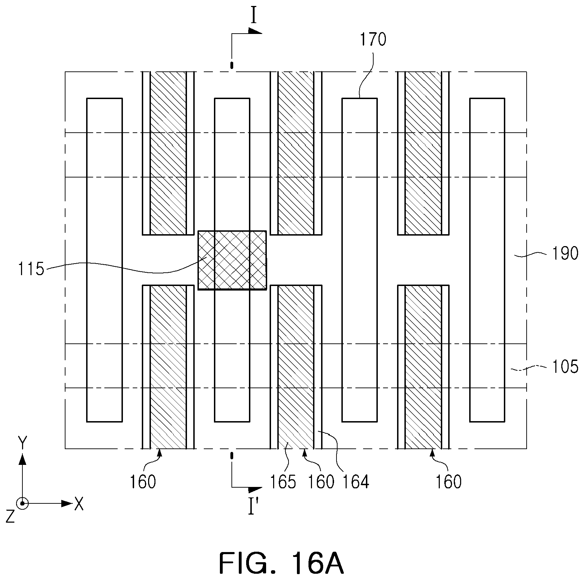

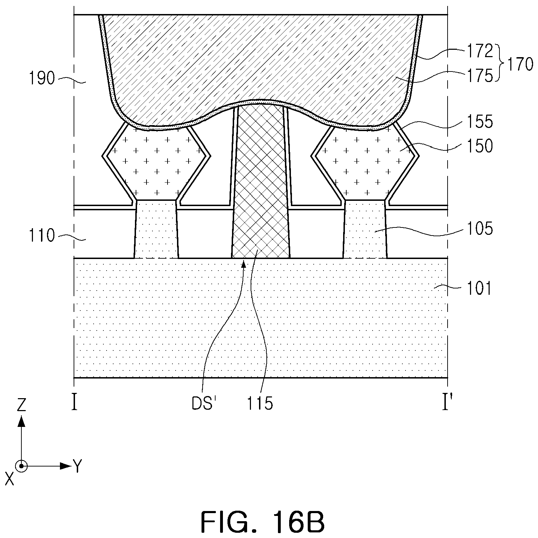

Referring to FIGS. 16A and 16B, contact plugs 170 may be formed.

The contact plugs 170 may be formed by forming contact holes by partially removing the interlayer insulating layer 190 and then depositing a conductive material. When the contact hole is formed, the source/drain regions 150 may be partially recessed. The vertical sacrificial layer 115 may also be partially recessed, but etching may be relatively less. Accordingly, an upper end of the vertical sacrificial layer 115 may be located at a higher level than upper ends of the source/drain regions 150 relative to the substrate 101. The contact plug 170 may be formed by sequentially forming a contact barrier layer 172 and a contact conductive layer 175 in the contact hole.

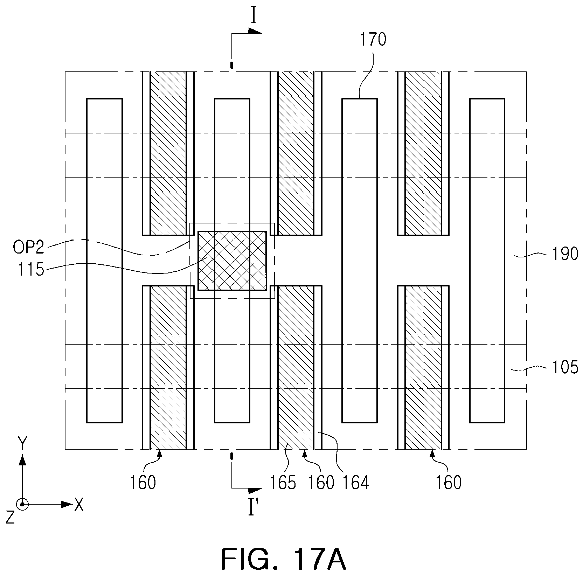

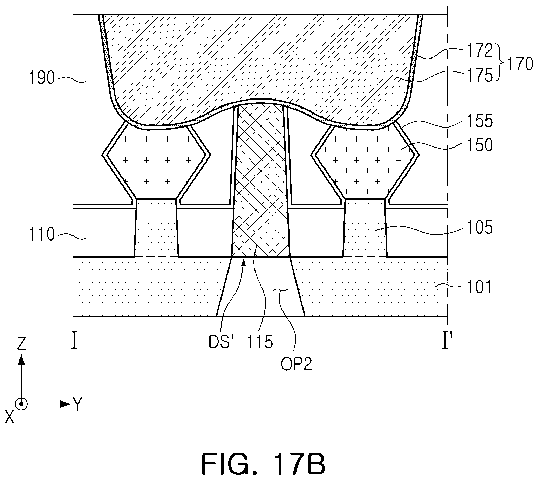

Referring to FIGS. 17A and 17B, a portion of the substrate 101 may be removed and a second opening OP2 penetrating the substrate 101 may be formed, e.g., from a back or lower surface of the substrate 101.

First, vias and interconnection lines may be further formed on the contact plugs 170. Subsequent processes may be performed after attaching a separate carrier substrate.

Substrate material may be removed from a lower surface of the substrate 101 to a predetermined thickness. The substrate material may be removed and thinned by, for example, a lapping, grinding, or polishing process. The thickness to which the substrate material is removed may vary in example embodiments.

The second opening OP2 may be formed to penetrate the substrate 101 in a position corresponding to the second power structure VS2 (see FIGS. 1 and 2A). The vertical sacrificial layer 115 constituting the dummy vertical structure DS' may be exposed through the second opening OP2.

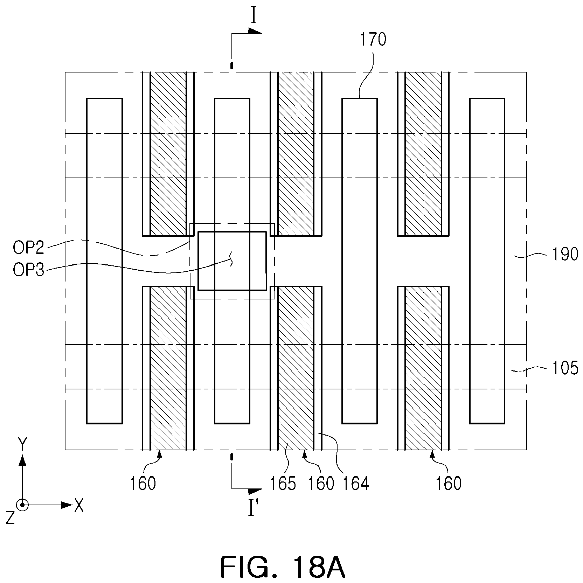

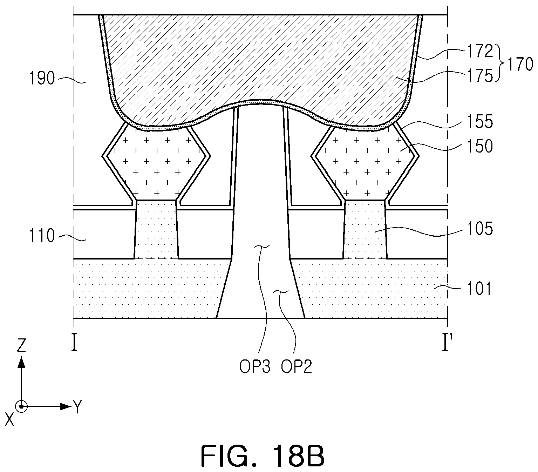

Referring to FIGS. 18A and 18B, a third opening OP3 may be formed by removing the vertical sacrificial layer 115.

The vertical sacrificial layer 115 may be selectively removed using, for example, a wet etching process. The third opening OP3 may be connected to the second opening OP2. The lateral dielectric layer 155 may be exposed through an inner side wall of the third opening OP3. In some embodiments, a portion of the lateral dielectric layer 155 exposed through the third opening OP3 may also be removed in this operation. In the case of the example embodiment of FIG. 5, in this operation, the vertical sacrificial layer 115 is removed and then the exposed lateral dielectric layers 155 may be overall removed.

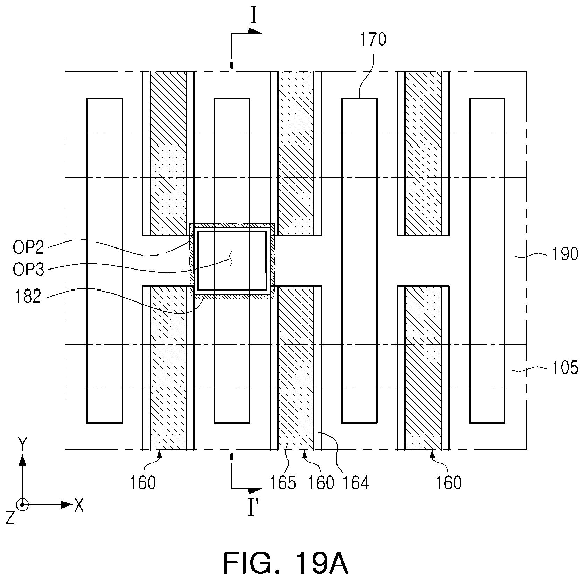

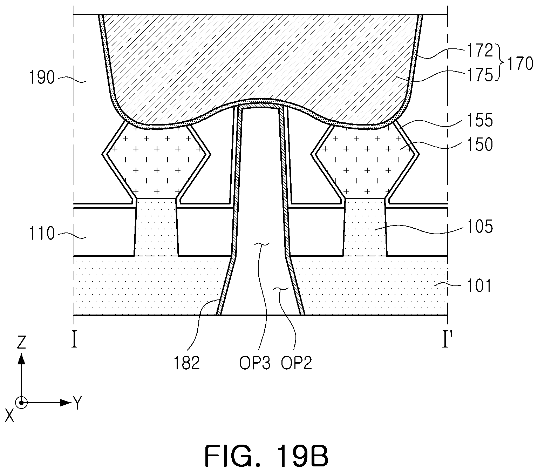

Referring to FIGS. 19A and 19B, a vertical barrier layer 182 may be formed in the second opening OP2 and the third opening OP3.

The vertical barrier layer 182 may be conformally formed to cover the surface of the substrate 101 exposed through the second opening OP2 and to cover surfaces of the device isolation layer 110, the lateral dielectric layer 155, and the contact plug 170, exposed through the third opening OP3.

Next, referring to FIGS. 19A and 19B and FIGS. 1 and 2A together, a vertical conductive layer 185 may be formed on the vertical barrier layer 182.

The vertical conductive layer 185 may fill the second opening OP2 and the third opening OP3. Accordingly, the first power structure VS1 and the second power structure VS2 including the vertical barrier layer 182 and the vertical conductive layer 185, respectively, may be formed. Thereafter, a planarization process may be performed.

As a result, the semiconductor device 100 of FIGS. 1 to 2C may be manufactured.

As set forth above, according to example embodiments, a semiconductor device having improved electrical characteristics and facilitated processing may be provided by including the first power structure formed using a dummy channel structure.

While example embodiments have been illustrated and described above, it will be apparent to those skilled in the art that modifications and variations could be made without departing from the scope of the present inventive concept as defined by the appended claims.

Embodiments are set out in the following clauses:
Clause 1. A semiconductor device comprising, a substrate including active regions extending in a first direction; a device isolation layer in the substrate to define the active regions, and exposing upper surfaces of the active regions; gate structures on the active regions, crossing the active regions and extending in a second direction; source/drain regions on the active regions and outside the gate structures; contact plugs on the source/drain regions, partially recessing the source/drain regions and connected to the source/drain regions; a first power structure between adjacent source/drain regions of the source/drain regions in the second direction and connected to at least one of the contact plugs; a second power structure below the first power structure, penetrating the substrate and connected to the first power structure; and a lateral dielectric layer covering surfaces of the source/drain regions and extending horizontally along an upper surface of the device isolation layer and covering a portion of a side surface of the first power structure, wherein the first power structure has a first width on an upper end and a second width on a lower end, the second width being equal to or greater than the first width.
Clause 2. The semiconductor device of clause 1, wherein the upper end of the first power structure is located on a level higher than levels of upper ends of the source/drain regions.
Clause 3. The semiconductor device of clause 1 or 2, wherein at least a portion of the first power structure is located on a level overlapping the source/drain regions.
Clause 4. The semiconductor device of any one of clauses 1 to 3, wherein the first power structure and the second power structure are integrally provided.
Clause 5. The semiconductor device of clause 4, wherein the first power structure includes a first barrier layer forming an upper surface and the side surface, wherein the first barrier layer continuously extends from the side surface of the first power structure to a side surface of the second power structure.
Clause 6. The semiconductor device of any one of clauses 1 to 5, wherein the contact plugs respectively include a second barrier layer forming a lower surface and a side surface, wherein the second barrier layer covers an upper surface of the first power structure.
Clause 7. The semiconductor device of any one of clauses 1 to 6, wherein lower ends of the contact plugs are located on a level higher than levels of lower ends of the source/drain regions.
Clause 8. The semiconductor device of any one of clauses 1 to 7, wherein the second power structure has a third width on an upper end and a fourth width on a lower end, the fourth width being greater than the third width.
Clause 9. The semiconductor device of clause 8, wherein the third width is equal to or greater than the second width.
Clause 10. The semiconductor device of any one of clauses 1 to 9, wherein the second power structure and the contact plugs respectively have an inclined side surface with a width narrowed toward an upper surface of the substrate.
Clause 11. The semiconductor device of any one of clauses 1 to 10, wherein a first contact plug among the contact plugs is provided between and connected to the source/drain regions adjacent to each other in the second direction, and the first power structure is connected to the first contact plug.
Clause 12. The semiconductor device of any one of clauses 1 to 11, wherein the lateral dielectric layer covers a region located on the device isolation layer, in the side surface of the first power structure.
Clause 13. The semiconductor device of any one of clauses 1 to 12, wherein a slope of the side surface of the first power structure is substantially equal to a slope of side surfaces of the active regions.
Clause 14. The semiconductor device of any one of clauses 1 to 13, further comprising a plurality of channel layers on the active regions, spaced apart from each other in a third direction, perpendicular to an upper surface of the substrate, and surrounded respectively by the gate structures.
Clause 15. A semiconductor device comprising, a substrate including an active region extending in a first direction; a gate structure on the active region, crossing the active region and extending in a second direction; a source/drain region outside the gate structure and on the active region; a contact plug on the source/drain region and connected to the source/drain regions; a first power structure on one side of the source/drain region in the second direction and connected to the contact plug; and a second power structure penetrating the substrate and connected to the first power structure, wherein the first power structure and the second power structure are integrated without an interface therebetween, and the first power structure has a first width on an upper and a second width on a lower end, the second width being equal to or greater than the first width.
Clause 16. The semiconductor device of clause 15, wherein the first power structure and the second power structure include a barrier layer forming an upper surface and a side surface of the first power structure and extending to form a side surface of the second power structure.
Clause 17. The semiconductor device of clause 15 or 16, wherein between the first power structure and the second power structure, a bent portion according to a change in side slope is provided.
Clause 18. The semiconductor device of clause 15, 16, or 17, further comprising a lateral dielectric layer covering a surface of the source/drain region, extending horizontally from the source/drain region to the first power structure, and covering a portion of a side surface of the first power structure.
Clause 19. A semiconductor device comprising, a substrate including an active region extending in a first direction; a gate structure on the active region, crossing the active region and extending in a second direction; a source/drain region outside the gate structure and on the active region; a contact plug on the source/drain region and connected to the source/drain regions; and a power structure on one side of the source/drain region in the second direction, extending in a third direction, perpendicular to the first and second directions, connected to the contact plug, and penetrating the substrate, wherein the power structure has a first width on an upper end and a second width on a lower end, the second width being greater than the first width.
Clause 20. The semiconductor device of clause 19, wherein the power structure includes an upper first power structure having a side surface of a first slope and a lower second power structure having a side surface of a second slope different from the first slope.

## Claims

1. A semiconductor device comprising:
a substrate comprising active regions extending in a first direction;
a device isolation layer in the substrate between the active regions and exposing upper surfaces of the active regions;
gate structures on the active regions, intersecting the active regions and extending in a second direction;
source/drain regions adjacent to the gate structures and on the active regions;
contact plugs on the source/drain regions, the contact plugs extending into respective recesses in the source/drain regions and electrically connected to the source/drain regions;
a first power structure between adjacent source/drain regions of the source/drain regions in the second direction and electrically connected to at least one of the contact plugs;
a second power structure on a lower end of the first power structure and penetrating the substrate; and
a lateral dielectric layer on surfaces of the source/drain regions and extending along an upper surface of the device isolation layer and on a first portion of a side surface of the first power structure,
wherein the first power structure has a first width at an upper end thereof and a second width at the lower end thereof, and the second width is equal to or greater than the first width.

2. The semiconductor device of claim 1, wherein the upper end of the first power structure is higher than respective upper ends of the source/drain regions relative to the substrate.

3. The semiconductor device of claim 1 or 2, wherein at least a portion of the first power structure overlaps the source/drain regions in the second direction.

4. The semiconductor device of claim 1, 2, or 3, wherein the first power structure and the second power structure are a unitary structure.

5. The semiconductor device of claim 4, wherein the first power structure comprises a first barrier layer on the upper end and the side surface,
wherein the first barrier layer continuously extends from the side surface of the first power structure to a side surface of the second power structure.

6. The semiconductor device of any one of claims 1 to 5, wherein the contact plugs respectively comprise a second barrier layer on a lower surface and a side surface thereof,
wherein the second barrier layer is on the upper end of the first power structure.

7. The semiconductor device of any one of claims 1 to 6, wherein lower ends of the contact plugs are higher than lower ends of the source/drain regions relative to the substrate.

8. The semiconductor device of any one of claims 1 to 7, wherein the second power structure has a third width at an upper end thereof and a fourth width at a lower end thereof, the fourth width being greater than the third width.

9. The semiconductor device of claim 8, wherein the third width is equal to or greater than the second width.

10. The semiconductor device of any one of claims 1 to 9, wherein the second power structure and the contact plugs comprise respective inclined side surfaces and respective widths that narrow toward an upper surface of the substrate.

11. The semiconductor device of any one of claims 1 to 10, wherein the at least one of the contact plugs is a first contact plug between and electrically connected to the adjacent source/drain regions in the second direction.

12. The semiconductor device of any one of claims 1 to 11, wherein a second portion of the side surface of the first power structure that protrudes beyond the device isolation layer is free of the lateral dielectric layer.

13. The semiconductor device of any one of claims 1 to 12, wherein a slope of the side surface of the first power structure is substantially equal to a slope of respective side surfaces of the active regions.

14. The semiconductor device of any one of claims 1 to 13, further comprising:
a plurality of channel layers on the active regions, spaced apart from each other in a third direction that is perpendicular to an upper surface of the substrate with portions of the gate structures therebetween.
